Europäisches Patentamt

European Patent Office

Office européen des brevets

(11) Publication number: **0 144 685**
**B1**

(12) **EUROPEAN PATENT SPECIFICATION**

(45) Date of publication of patent specification: **16.05.90**

(51) Int. Cl.⁵: **C 23 C 18/40**

(21) Application number: **84112876.2**

(22) Date of filing: **26.10.84**

(54) Electroless copper plating process.

(30) Priority: **31.10.83 US 547298**

(43) Date of publication of application:
**19.06.85 Bulletin 85/25**

(45) Publication of the grant of the patent:
**16.05.90 Bulletin 90/20**

(84) Designated Contracting States:
**DE FR GB**

(56) References cited:
**FR-A-2 371 522**
**US-A-3 844 799**

**The file contains technical information
submitted after the application was filed and
not included in this specification**

(73) Proprietor: **International Business Machines
Corporation
Old Orchard Road
Armonk, N.Y. 10504 (US)**

(72) Inventor: **Capwell, Robert John
2605 Pine Bluff Drive
Vestal, N.Y. 13 850 (US)**
Inventor: **Kaschak, Ronald Anthony
316 Fordham Road Apt. 2
Vestal, N.Y. 13 850 (US)**
Inventor: **Mc Bride, Donald Gene
2058 Cheshire Road
Binghamton, N.Y. 13 903 (US)**
Inventor: **Rickert, Robert George
2705 Foster Street
Endwell, New York (US)**
Inventor: **Seraphim, Donald Phillip
400 Rano Boulevard
Vestal, N.Y. 13 850 (US)**

(74) Representative: **Oechssler, Dietrich, Dr. rer. nat.
IBM Deutschland GmbH Patentwesen und
Urheberrecht Schönaicher Strasse 220
D-7030 Böblingen (DE)**

Courier Press, Leamington Spa, England.

## Description

The invention relates to a process for plating copper onto a substrate from an electroless plating bath containing a source of cupric ions, a reducing agent for the cupric ion and a complexing agent for the cupric ion.

The electroless plating of copper onto a substrate is well-known in the prior art. For instance, an electroless or autocatalytic copper plating bath usually contains a cupric salt, a reducing agent for the cupric salt, a chelating or complexing agent, and a pH adjuster. In addition, if the surface being plated is not already catalytic for the deposition of the desired metal, a suitable catalyst is deposited on the surface prior to contact with the plating bath. Among the more widely employed procedures for catalyzing a substrate is the use of stannous chloride sensitizing solution and a palladium chloride activator to form a layer of metallic palladium particles.

Although the technology relative to electroless copper plating is continually being improved, there still remains room for additional improvement. Certain problems are especially pronounced when preparing articles of very high quality such as those to be employed in printed circuit applications, e.g., printed circuit boards which contain high-density circuitry and large numbers of holes such as through-holes and blind holes. The problems encountered include the formation of voids on the surface and in the coatings located in the holes. This, in turn, can cause unreliable electrical connections. Moreover, even if the electrical connections initially are adequate, the presence of voids tends to cause the coatings to crack during use of the circuits. During operation, integrated circuit boards tend to expand and contract somewhat. Any discontinuities in the coating represent a prime site for cracking due to the mechanical stress from such expansion and contraction.

Moreover, a major reason for yield loss in electroless plating is the formation of what is known as extraneous copper or nodules. The formation of nodules in unwanted areas on a substrate can result in short-circuiting by forming contact between circuit lines on the substrate. In addition, such processes as providing protective coatings, providing solder, and pin insertion are adversely effected by the presence of nodules on the surface.

Various attempts to reduce void formation result in significant increase in the formation of nodules. Likewise, attempts to reduce nodule formation have resulted in significant increase in void formation. Accordingly, it would be advantageous and desirable to reduce the formation of voids without a significant increase in the formation of extraneous copper or nodules.

FR—A—2371522 describes an electroless copper plating process which is operated in a narrow range of the mix potential preferably from −630 mV to −760 mV with a calomel electrode, wherein the temperature is in the range of 40 to 95°C.

It is the object of the invention to provide a process for depositing copper onto a substrate from an electroless plating solution where void formation is reduced or even entirely eliminated without significantly increasing the formation of extraneous copper or nodules.

This object is achieved by a process as defined at the beginning of this specification having the features of claim 1.

The mix potential of the bath is monitored during plating, since the composition and with it the mix potential of the bath tend to drift or change during the plating.

Advantageous embodiments of the inventive process are disclosed in the subclaims.

The inventive process will become more apparent from the following detailed description.

According to the present invention, it has been found that improved plating can be achieved by providing and maintaining a copper plating bath having a mix potential relative to a saturated calomel electrode of about minus 675 to about minus 630, preferably about minus 650 to about minus 630, and most preferably about minus 630 at a temperature of about 73°C.

By maintaining the mix potential of the plating at the preferred value of about minus 630, minimum nodule formation is achieved with a small sacrifice in reducing void formation. The value of about minus 675 provides for the minimum void formation, but with a somewhat greater, but acceptable, sacrifice in the amount of nodules which tend to form. The former situation and conditions are preferred.

The potential of operation of the bath, the mix potential or EMIX, is between the potential which characterizes the reduction of the cupric ion in the absence of the reducing agent and the potential which characterizes the oxidation of the reducing agent in the absence of the cupric ions.

The mix potential is monitored by placing a saturated calomel electrode and copper surface or coupon into the bath and electrically connecting a millivoltmeter to the calomel electrode and copper surface. When the bath temperature is not 73°C, the above values for the mix potential are adjusted upwardly or downwardly, depending upon the temperature of the bath in accordance with well-known tables.

The surface upon which the copper is plated must be catalytic for the deposition of copper. In the event the surface being plated is not already catalytic for the deposition of the copper, a suitable catalyst is deposited on the surface prior to contact with the plating bath. Among the more widely employed procedures for catalyzing a substrate is the use of a stannous chloride sensitizing solution and a palladium chloride activator to form a layer of metallic palladium particles. One such surface is an epoxy-fiberglass laminate containing already deposited copper in those areas where copper is to be plated and/or being seeded with a stannous chloride and palladium chloride activating system.

The copper electroless plating bath is generally an aqueous composition which includes a source of cupric ion, a reducing agent, a complexing agent for the cupric ion, and a pH adjuster. The plating baths also preferably include a cyanide ion source and a surface-active agent.

The cupric ion source generally used is a cupric sulfate (e.g., $CuSO_4 \cdot 5H_2O$) or a cupric salt of the complexing agent to be employed.

It is preferred to use amounts of cupric ion source from about 3 to about 15 g/l calculated as $CuSO_4 \cdot 5H_2O$. The most common reducing agent employed is formaldehyde which, in the preferred aspects of the present invention, is used in amounts from about 0.7 to about 7 g/l.

Examples of some other reducing agents include formaldehyde precursors or derivatives such as paraformaldehyde, trioxane, dimethylhydantoin, glyoxal; borohydrides such as alkali metal borohydrides (sodium and potassium borohydride) and substituted borohydrides such as sodium trimethoxy borohydride; boranes such as amine borane (isopropyl amine borane and morpholine borane).

Examples of some suitable complexing agents include Rochelle salts, ethylene diamine tetraacetic acid, the sodium (mono-, di-, tri-, and tetrasodium) salts of ethylene diamine tetraacetic acid, nitrolotetraacetic acid and its alkali salts, gluconic acid, gluconates, triethanol amine, glucono (gamma)-lactone, modified ethylene diamine acetates such as N-hydroxyethyl, and ethylene diamine triacetate. In addition, a number of other suitable cupric complexing agents are suggested in U.S. Patents 2 996 408; 3 075 856; 3 075 855; and 2 938 805. The amount of complexing agent is dependent upon the amount of cupric ions present in the solution and is generally from about 20 to about 50 g/l.

The plating bath can also include a surfactant which assists in wetting the surface to be coated. A satisfactory surfactant is, for instance, an organic phosphate ester available under the trade designation "Gafac RE-610". Generally, the surfactant is present in amounts from about 0.02 to about 0.3 g/l. In addition, the pH of the bath is also generally controlled, for instance, by the addition of a basic compound such as sodium hydroxide or potassium hydroxide in the desired amount to achieve the desired pH. The preferred pH of the electroless plating bath is between about 11.6 and 11.8.

Also, preferably, the plating bath contains a cyanide ion and most preferably contains about 10 to about 25 mg/l to provide a cyanide ion concentration in the bath within the range of 0.0002 to 0.0004 molar. Examples of some cyanides which can be employed according to the present invention are the alkali metal, alkaline earth metal, and ammonium cyanides. In addition, the plating bath can include other minor additives as is known in the art.

The preferred plating baths employed have a specific gravity within the range of 1.060 to 1.080. Moreover, the temperature of the bath is preferably maintained between about 70°C and 80°C, preferably between about 70°C and 75°C and most preferably about 73°C.

For a discussion of the preferred plating temperature coupled with the preferred cyanide ion concentrations, see U.S. Patent 3 844 799.

Also, it is preferred to maintain the $O_2$ content of the bath between about 2 ppm and 4 ppm and preferably about 2.5 to about 3.5 ppm, as discussed in U.S. Patent 4 152 467. The $O_2$ content can be controlled by injecting oxygen and an inert gas into the bath.

The overall flow rate of the gases into the bath is generally from about 7.5 to about 149.6 standardlitres per 1000 litres (about 1 to about 20 SCFM per thousand gallons) of bath and preferably from about 22.5 to about 59.9 standardlitres per 1000 litres (about 3 to about 8 SCFM per thousand gallons) of bath.

Although the above ranges of constituents referred to above are the same as those disclosed in U.S. Patent 4 152 467, none of the examples therein have the necessary particular mix potential values required by the present invention, since not all combinations of amounts within the above ranges will provide the desired mix potential values. It is necessary to select proper combinations of amounts of the ingredients to achieve the desired mix potential values. However, once a person skilled in the art is aware of the present invention and criticality of the mix potential values disclosed herein, the preparation of plating baths to achieve these potentials can be determined without undue experimentation.

In the event the mix potential of the bath is determined to be outside of the specified range, the cupric ion content, reducing agent content, oxygen content, complexing agent, and cyanide salt content are determined by well-known testing techniques to determine if any one or more of these constituents are outside of the ranges given above and if so, the amount of constituent(s) outside of the ranges discussed hereinabove is adjusted accordingly. In addition, if the amounts of such constituents are within the ranges discussed hereinabove, but the mix potential is outside of the range specified hereinabove, one can then investigate for possible bath contaminates and if found, can remove such from the bath.

Moreover, if the amounts of such constituents are within the ranges discussed hereinabove, but the mix potential is outside of the range specified hereinabove, the mix potential can be lowered by increasing the reducing agent and/or the complexing agent and/or reducing the cupric ion concentration, but still maintaining the amounts of each within the ranges discussed hereinabove. The relative amount of any increase or decrease of constituent can be determined without undue experimentation.

The determination of the various amounts of the above substituents can be carried out by well-known analytical techniques using well-known equipment which need not be described herein in any great detail. For instance, the dissolved oxygen can be determined by use of a dissolved oxygen meter probe such as a Leeds and Northrup Monitor 7931—10 and Probe 7931—30.

The cyanide concentration can be determined by a cyanide electrode and meter such as a Beckman Monitor 646949 pH-Model 942 and Graphic Controls Probe pH 193150 having a pH range of 11—13. The cupric salt can be determined by a UV—VIS (ultra-violet/visible) spectrophotometer. For example, a Gilford Spectrophotometer Model STA—SAR 2 can be used for the cupric salt determination. The complexing agent and reducing agent can be determined by known potentiometric titrations.

Tests conducted employing plating baths as described hereinabove with mix potentials in the ranges specified above and particularly, about minus 650 millivolts and about minus 630 millivolts, results in quantities of plating voids of less than one per side, while plated manufacturing subassemblies have quantities of plating voids from about 20 per side to about 8 per side with plating baths of the same constituents (i.e., the preferred baths disclosed in U.S. Patent 4 152 467), but having mix potential of about minus 580 millivolts.

Also, tests conducted on laboratory plating cells using a plating bath of about minus 630 millivolts show about 1/2 to about 1/5 the plating voids produced with plating baths of the same constituents disclosed in U.S. Patent 4 152 467, but having a mix potential of about minus 580 millivolts. In addition, the nodule formation in the baths, in accordance with the present invention, is not significantly increased as compared to the baths with potential of about minus 580 millivolts.

## Claims

1. Process for plating copper onto a substrate from an electroless plating bath containing a source of cupric ions, a reducing agent for the cupric ions and a complexing agent for the cupric ions, characterized in that said bath is kept at a temperature between 70 and 80°C and the mix potential relative to a saturated calomel electrode is adjusted within the range of minus 630 to minus 675 mV referred to a temperature of about 73°C, that said mix potential is monitored during plating and that the composition of the bath is adjusted during plating to maintain the mix potential during plating within the said millivolt range.

2. Process according to claim 1 wherein the mix potential range is adjusted upwardly or downwardly upon the temperature of the bath within said temperature range.

3. Process according to claim 1 or 2 wherein said mix potential is about minus 630 to about minus 650 millivolts.

4. Process according to any one of claims 1 to 3 wherein the temperature of said bath is maintained between about 70°C and about 75°C during the plating.

5. Process according to any one of claims 1 to 4, wherein as the source of cupric ion cupric sulfate, as the reducing agent formaldehyde, as the complexing agent ethylene diamine tetraacetic acid or a salt thereof are selected.

6. Process according to any one of claims 1 to 5 wherein cyanide ions are added to said bath.

7. Process according to any one of claims 1 to 6 wherein a pH value adjuster and a surfactant are added to said plating bath.

8. Process according to any one of claims 1 to 7 wherein the composition of said bath is adjusted to maintain said mix potential during plating by adjusting at least one member of the group of cupric ion content, reducing agent content, oxygen content, complexing agent, and cyanide ion content.

9. Process according to any one of claims 1 to 8 wherein the pH value of said bath is about 11.6 to about 11.8.

10. Process according to any one of claims 1 to 9, wherein said electroless plating bath comprises per liter of solution 3 to 15 g of a copper salt, calculated as $CuSO_4 \cdot 5H_2O$, 0.7 to 7 g formaldehyde, 20 to 50 g of a complexing agent, 0.02 to about 0.3 g of a wetting agent, 0.0002 to 0.0004 moles of $CN^-$ and preferably 2 to 4 ppm of $O_2$.

## Patentansprüche

1. Verfahren zum Plattieren eines Substrats mit Kupfer aus einem stromlosen Plattierungsbad, das eine Kupfer(II)-ionenquelle, ein Reduktionsmittel, sowie einen Komplexbildner für die Kupfer(II)-ionen enthält, dadurch gekennzeichnet, daß das Bad auf einer Temperatur zwischen 70 und 80°C gehalten und das Mischpotential gegenüber einer gesättigten Kalomelelektrode innerhalb des Bereichs von minus 630 bis minus 675 mV bezogen auf eine Temperatur von ca. 73°C eingestellt wird, daß das Mischpotential während des Plattierens überwacht und die Zusammensetzung des Bads während des Plattierens entsprechend eingestellt wird, um das Mischpotential während des Plattierens innerhalb des genannten Millivolt-Bereichs zu halten.

2. Verfahren nach Anspruch 1, bei dem der Bereich des Mischpotentials nach oben oder unten je nach der Badtemperatur innerhalb des Temperaturbereichs eingestellt wird.

3. Verfahren nach Anspruch 1 oder 2, bei dem das Mischpotential ca. minus 630 bis ca. minus 650 Millivolt beträgt.

4. Verfahren nach einem der Ansprüche 1 bis 3, bei dem die Temperatur des Bades zwischen ca. 70°C und ca. 75°C während des Plattierens gehalten wird.

5. Verfahren nach einem der Ansprüche 1 bis 4, bei dem als Kupfer(II)-ionenquelle Kupfer(II)-sulfat, als Reduktionsmittel Formaldehyd und als Komplexbildner Ethylendiamintetraessigsäure oder ein Salz derselben ausgewählt wird.

6. Verfahren nach einem der Ansprüche 1 bis 5, bei dem Zyanidionen dem Bad hinzugefügt werden.

7. Verfahren nach einem der Ansprüche 1 bis 6, bei dem ein pH-Wert-Einsteller sowie ein oberflächenaktives Mittel dem Plattierungsbad hinzugefügt werden.

8. Verfahren nach einem der Ansprüche 1 bis 7, bei dem die Zusammensetzung des Bades so eingestellt wird, daß das Mischpotential während des Plattierens dadurch aufrechterhalten wird, daß mindestens ein Glied de Gruppe aus Kupfer(II)-ionengehalt, Reduktionsmittelgehalt, Sauerstoffgehalt, Komplexbildner und Zyanidionengehalt eingestellt wird.

9. Verfahren nach einem der Ansprüche 1 bis 8, bei dem der pH-Wert des Bades ca. 11.6 bis ca. 11.8 beträgt.

10. Verfahren nach einem der Ansprüche 1 bis 9, bei dem das stromlose Plattierungsbad pro Liter Lösung 3—15 g eines Kupfersalzes kalkuliert als $CuSO_4 \cdot 5H_2O$, 0.7—7 g Formaldehyd, 20—50 g eines Komplexbildners, 0,02 — ca. 0,3 g eines Netzmittels, 0,0002—0,0004 Mol $CN^-$ und bevorzugt 2—4 ppm $O_2$ enthält.

**Revendications**

1. Procédé pour déposer du cuivre sur un substrat à partir d'un bain de dépôt par voie non électrique contenant une source d'ions cuivriques, un agent réducteur pour les ions cuivriques et un agent complexant pour les ions cuivriques, caractérisé en ce que ce bain est maintenu à une température comprise entre 70°C et 80°C et que le potentiel du mélange par rapport à une électrode au calomel saturée est ajusté dans la gamme de moins 630 à moins 675 mV rapporté à une température d'environ 73°C, que ce potentiel du mélange est suivi pendant le dépôt et que la composition du bain est ajustée pendant le dépôt pour maintenir le potentiel du mélange dans cette gamme de millivolts pendant le dépôt.

2. Procédé suivant la revendication 1, caractérisé en ce que la gamme de potentiel du mélange est ajustée vers le haut ou vers le bas en fonction de la température du bain dans cette gamme de températures.

3. Procédé suivant la revendication 1 ou 2, caractérisé en ce que le potentiel du mélange est d'environ moins 630 à moins 650 millivolts.

4. Procédé suivant l'une quelconque des revendications 1 à 3, caractérisé en ce que le température de ce bain est maintenu entre environ 70°C et 75°C pendant le dépôt.

5. Procédé suivant l'une quelconque des revendications 1 à 4, caractérisé en ce qu'on choisit du sulfate cuivrique en tant que source d'ions cuivriques, du formaldéhyde comme agent réducteur, de l'acide éthylène diamine tétracétique ou un sel de celui-ci comme agent complexant.

6. Procédé suivant l'une quelconque des revendications 1 à 5, caractérisé en ce que des ions cyanure sont ajoutés à ce bain.

7. Procédé suivant l'une quelconque des revendications 1 à 6, caractérisé en ce qu'un agent ajustant le pH et un agent tensioactif sont ajoutés à ce bain de dépôt.

8. Procédé suivant l'une quelconque des revendications 1 à 7, caractérisé en ce que la composition de ce bain est ajustée pour maintenir ce potentiel du mélange pendant le dépôt par ajustement d'au moins l'un des facteurs du groupe comprenant la teneur en ion cuivrique, la teneur en agent réducteur, la teneur en oxygène, l'agent complexant et la teneur en ion cyanure.

9. Procédé suivant l'une quelconque des revendications 1 à 8, caractérisé en ce que le pH de ce bain est d'environ 11,6 à 11,8.

10. Procédé suivant l'une quelconque des revendications 1 à 9, caractérisé en ce que ce bain de dépôt par voie non électrique comprend pour un litre de solution, 3 à 15 g d'un sel de cuivre, calculé en tant que $CuSO_4 \cdot 5H_2O$, 0,7 à 7 g de formaldéhyde, 20 à 50 g d'un agent complexant, 0,02 à 0,3 g d'un agent mouillant, 0,0002 à 0,0004 mole de $CN^+$ et de préférence 2 à 4 ppm de $O_2$.